(19) Europäisches Patentamt
European Patent Office
Office européen des brevets

(11) **EP 4 738 432 A1**

(12) **EUROPEAN PATENT APPLICATION**

(43) Date of publication:
**06.05.2026 Bulletin 2026/19**

(21) Application number: **24209456.3**

(22) Date of filing: **29.10.2024**

(51) International Patent Classification (IPC):
***H01L 23/00*** *(2006.01)*

(52) Cooperative Patent Classification (CPC):
**H10W 72/20; H10W 20/47; H10W 20/495;**
H10W 72/01935; H10W 72/01955; H10W 72/29;
H10W 72/9226; H10W 72/923; H10W 72/926;
H10W 72/934; H10W 72/9415; H10W 72/942;
H10W 72/9445; H10W 72/952

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **NXP B.V.**
**5656 AG Eindhoven (NL)**

(72) Inventors:
 • **Manzi, Giuliano**
 **5656 AG Eindhoven (NL)**

 • **Kolaric, Vlatko**
 **5656 AG Eindhoven (NL)**
 • **Eiper, Ernst**
 **5656 AG Eindhoven (NL)**
 • **Zenz, Christian**
 **5656 AG Eindhoven (NL)**

(74) Representative: **Hardingham, Christopher Mark**
**NXP Semiconductors**
**Intellectual Property Group**
**The Cattle Barn**
**Upper Ashfield Farm, Hoe Lane**
**Romsey, Hampshire SO51 9NJ (GB)**

(54) **SEMICONDUCTOR DEVICE AND METHOD OF FABRICATION**

(57) A semiconductor device and method of fabrication are described. The device comprising: a semiconductor RFID IC base layer (201); a passivation layer (203) located over the base layer, having a metal insert (204) within the passivation layer; a repassivation layer (205) located over the passivation layer and the metal insert; a assembly pad layer (207) located over the repassivation layer; wherein the device (250) has: a first region R1 (252) of the device, where a height of the repassivation layer is given by $d_1$, and region R1 is provided with an assembly pad in the assembly pad layer (207) over the repassivation layer, that has an area $A_1$; and an nth region RN (256) of the device, where the height of the repassivation layer is given by $d_n$, where $d_1 > d_n$ and region RN is provided with an assembly pad in the bump layer (207) over the repassivation layer, which has an area $a_n$, where $A_n > A_1$.

FIG 4

**(Cont. next page)**

EP 4 738 432 A1

**FIG 4(e)**

**Description**

Technical Field

The technical field relates to the fabrication of a semiconductor device with improved radio frequency (RF) input reactive impedance variation over the semiconductor wafer. The technical field is applicable to, but not limited to, a Radio-Frequency Identification (RFID) Integrated Circuit (IC) which enables automatic identification and tracking, as well as sensors such as capacitance sensors, temperature sensors and humidity sensors.

Background

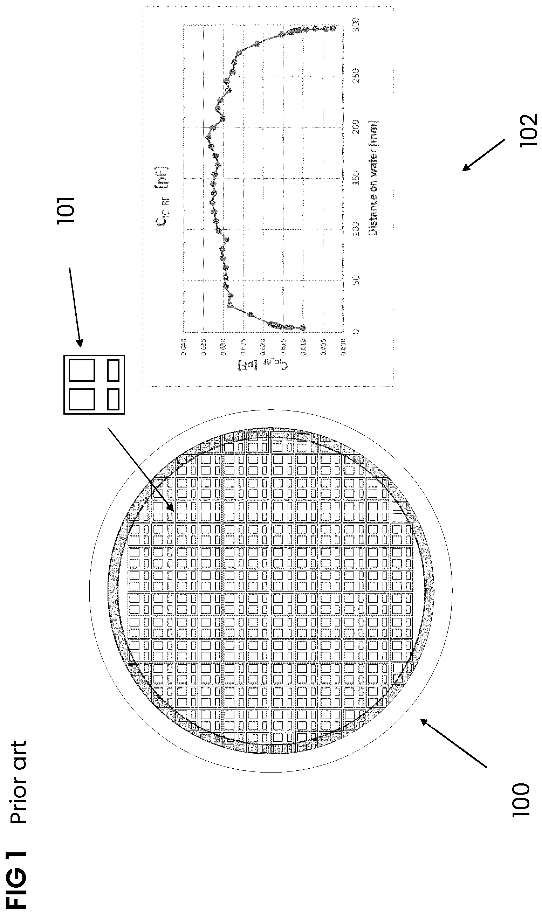

Due to the intrinsic effects of the wafer manufacturing process, the radio frequency (RF) input impedance of a Radio-Frequency Identification Integrated Circuit (RFID IC) may vary over a wafer. This is illustrated in FIG. 1, where a semiconductor wafer 100, with RFID semiconductor ICs 101 is shown alongside graph 102, showing the variation in capacitance across the wafer. As shown, there is significant variation in capacitance across the wafer 100. This variation of input impedance has a strong impact on overall RFID label performances (for example, a variation of 5% in the input impedance may have up to 3dB degradation in performances of the final RFID assembly).

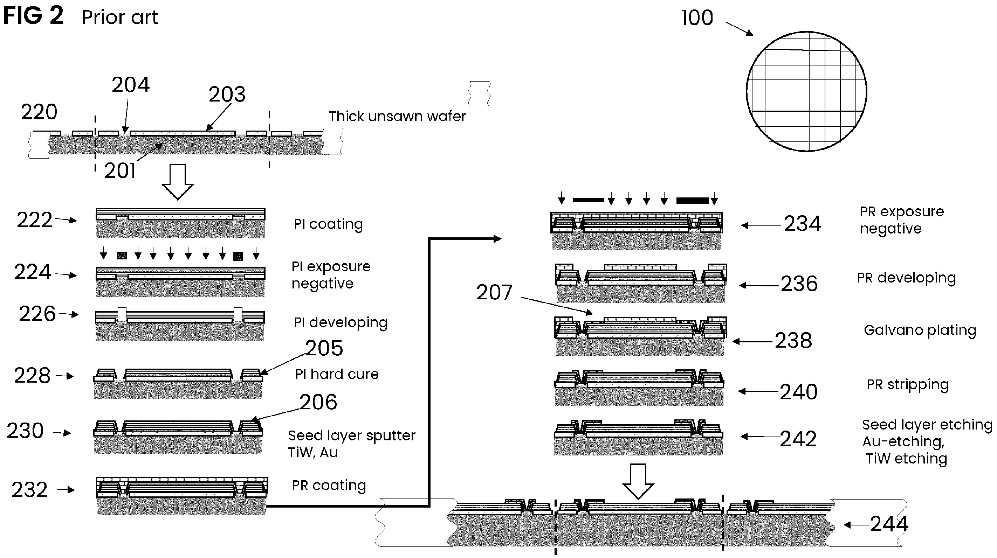

FIG. 2 is an illustration of the steps in a known bumping process. The process shown is a modification of a standard repassivation and re-distribution process and is generally carried out on a thick wafer. As shown, at step 220 a thick unsawn wafer is provided, typically a silicon substrate, with a bond pad 204, and passivation layer 203 on top semiconductor die 201. Step 222 is provision of the Polyimide layer (PI) coating, and this is followed by step 224, PI exposure. This is followed by step 226, developing the PI layer. After this is step 228, hard cure of the PI layer. This is followed by step 230, seed layer sputter, and then step 232, provision of photoresist (PR) coating. This is followed by step 234, PR exposure, step 236, PR developing, step 238 Galvano plating, step 240 PR stripping, and step 242 seed layer etching, Au etching and TiW etching. The result of these process steps is a thick unsawn wafer 244 with repassivation layer and large area pads. Typically, a plurality of RFID semiconductor ICs will be processed on a single wafer. The bump process is processing the Repassivation and redistribution layer, processed on a wafer. The pre-assembly stage includes electrical Testing of the wafers, thinning, mounting on Film Frame Carriers (FFC), dicing in to singulated ICs. The final assembly step of the RFID semiconductor is assembly with an antenna by Flip Chip Thermocompression process.

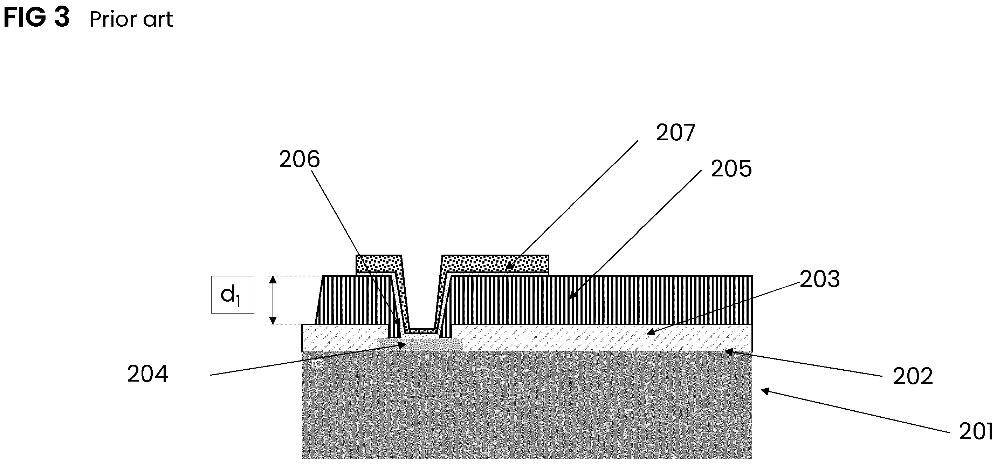

Referring now to FIG. 3, this shows a partial cross-sectional view of the RFID semiconductor die 201, with extra fabrication components that have been placed on the wafer during the fabrication process of Figure 2. Above the top surface metal layer of the die 201 is passivation layer 203, this is preferably a SiO or, SiN layer. A metallic bond pad, with a typical size of $50 \times 50 \mu m$ is shown at 204, preferably this is an aluminium bond pad. A repassivation layer is shown at 205, this is preferably, a Polyimide layer (PI) or a Polybenzoxazoles (PBO) layer, with a typical thickness of $3-20\mu m$. Feature 206 is an Under Bump Metallization, formed from sputtered TiW/ Au flash with a thickness of 100nm-1000nm. This feature connects the Bond pads, acts as a barrier layer, increases adhesion, and is used as seed layer for subsequent Au-deposition by electroplating. Feature 207 are large connection Pads, typically these are electroplated Au-pads ("bump") of $1-10\mu m$ Au for connection with RFID antenna ($200 \times 200\mu m$) depending on IC size). Aalternatively the bumps may be formed of Cu for example.

The inventors have recognised and appreciated that a solution that enables better control of, or reduction in, the variation of the impedance over the wafer will bring a final RFID assembly having a limited variation in performance and better manufacturing yield. Accordingly, there is a need for an improved semiconductor die and method of fabrication.

Summary of the invention

The present invention provides a semiconductor die and method of fabrication of the semiconductor die, as described in the accompanying claims. Specific embodiments are set forth in the dependent claims. These and other aspects will be apparent from and elucidated with reference to the embodiments described hereinafter.

Brief description of the drawings

Further details, aspects and embodiments will be described, by way of example only, with reference to the drawings. In the drawings, like reference numbers are used to identify like or functionally similar elements. Elements in the figures are illustrated for simplicity and clarity and have not necessarily been drawn to scale.

FIG. 1 illustrates a plan view of a prior art semiconductor wafer and a graph showing how the capacitance / impedance changes across the wafer;

FIG. 2 illustrates a prior art bumping process;

FIG. 3 shows a cross section of a partial semiconductor die according to the prior art;

FIG. 4(a) shows a plan view of an RFID semiconductor wafer according to an example embodiment;

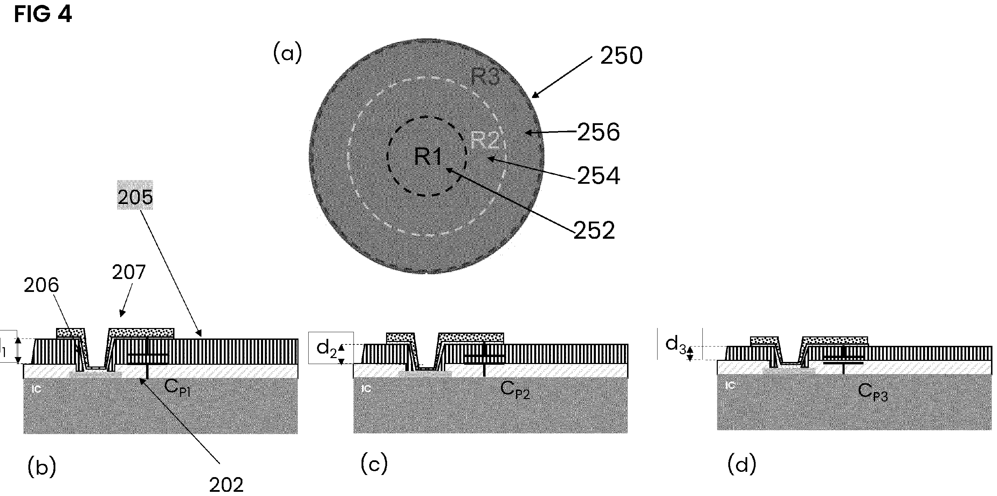

FIG's 4(b), (c) and (d) are alternative cross-sectional views of parts the semiconductor dies from a wafer in FIG. 4(a) in regions R1, R2 and R3 respectively;

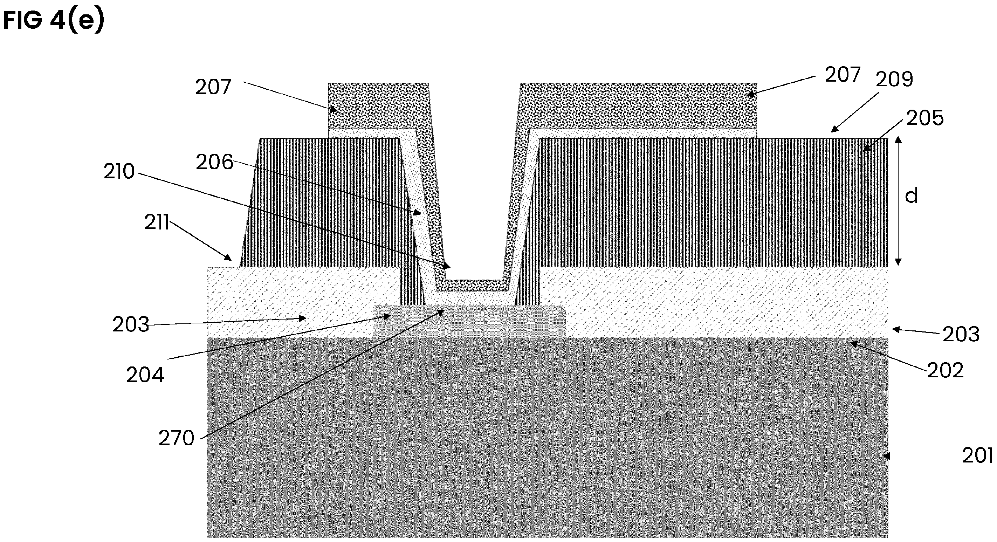

FIG. 4 (e) is a close up of part of the region shown in FIGs 4(b)-(d);

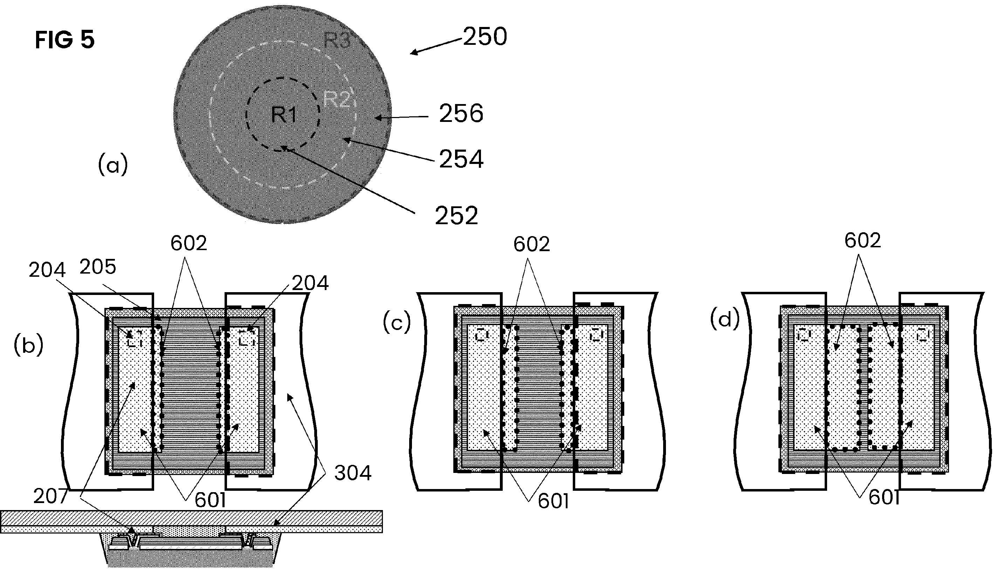

FIG. 5(a) is a plan view of a semiconductor wafer according to an example embodiment;

FIG's 5(b)-5(d) show alternative plan views of the semiconductor dies of FIG. 5(a) in regions R1, R2 and R3 respectively, according to an example embodiment;

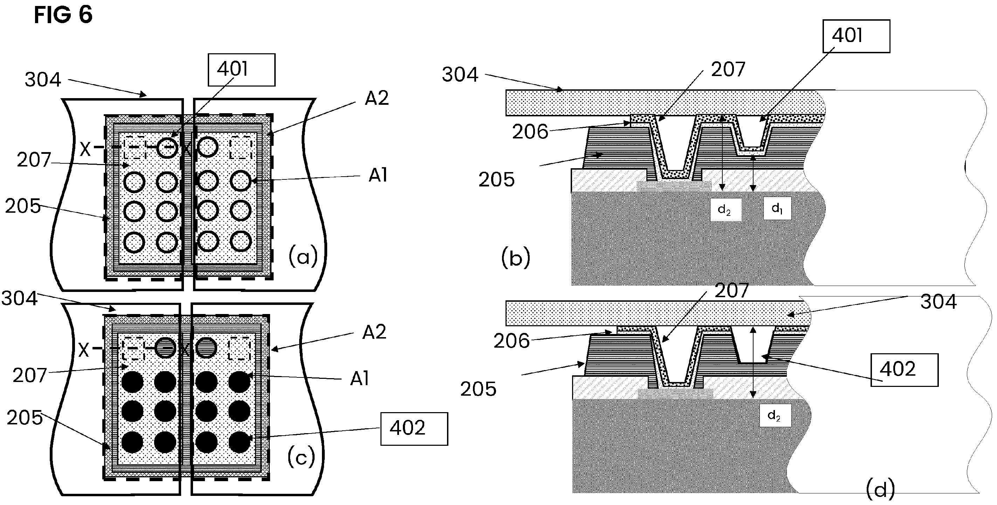

FIG. 6(a) is a plan view of the RFID semiconductor die assembled on an antenna that includes one or more cavities in a passivation layer, according to an example embodiment;

FIG. 6(b) is a cross-sectional view corresponding to the plan view of FIG. 6(a);

FIG. 6(c) is a plan view of the RFID semiconductor die assembled on an antenna that includes one or more non metallized cavities in a passivation layer, according to an example embodiment;

FIG. 6(d) is a cross-sectional view corresponding to the plan view of FIG. 6(c);

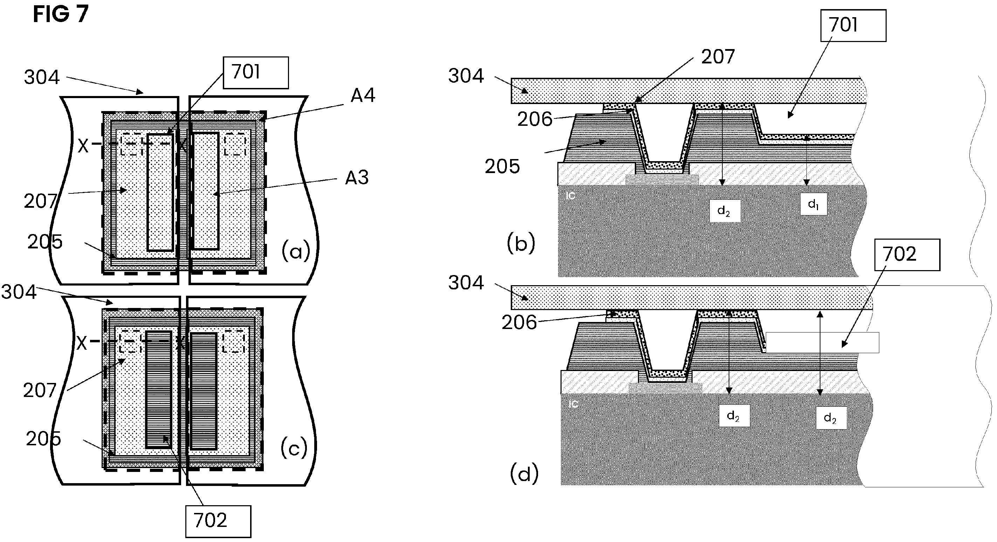

FIG. 7(a) is a plan view of the RFID semiconductor die assembled on an antenna that includes one or more trenches in a passivation layer, according to an example embodiment;

FIG. 7(b) is a cross-sectional view corresponding to the plan view of FIG. 7(a);

FIG. 7(c) is a plan view of the RFID semiconductor die assembled on an antenna that includes one or more non metallized trenches in a passivation layer, according to an example embodiment;

FIG. 7(d) is a cross-sectional view corresponding to the plan view of FIG. 7(c);

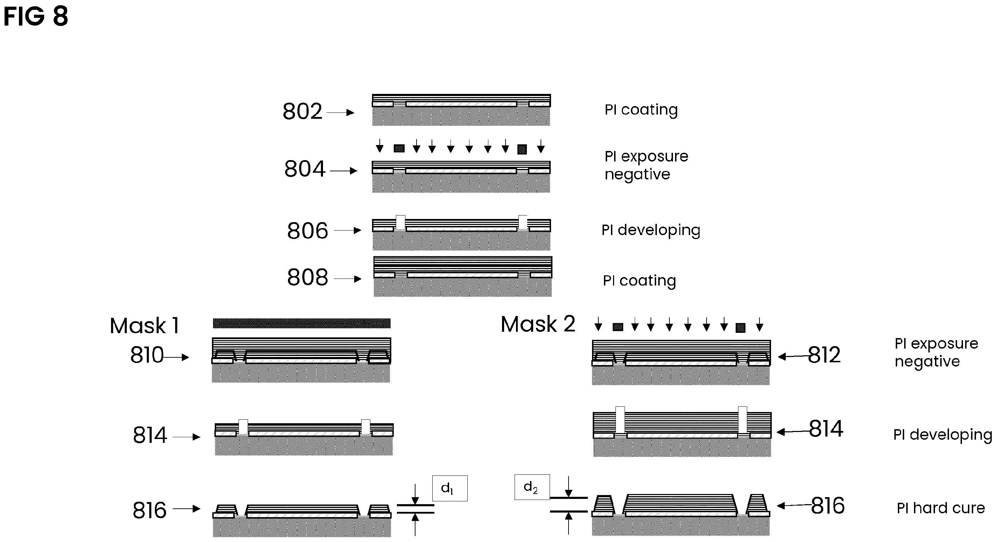

FIG. 8 illustrates the schematic flow for modified repassivation process on an RFID semiconductor die, according to an example embodiment;

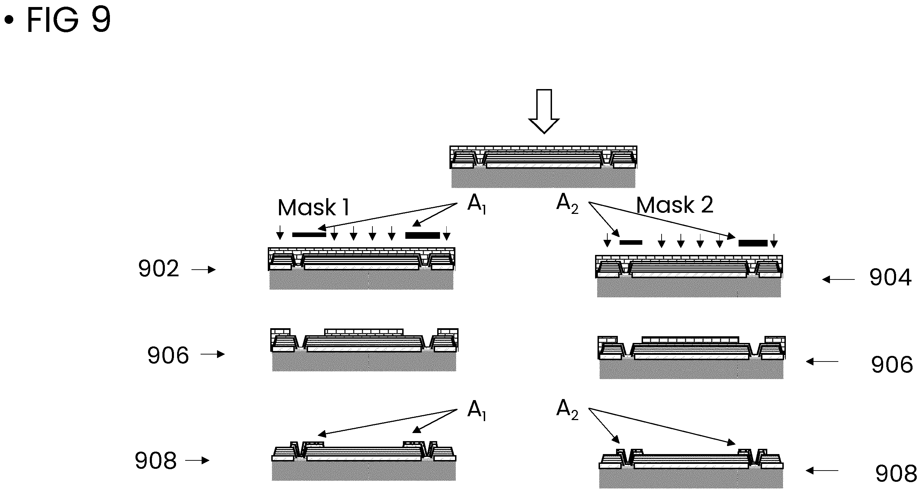

FIG. 9 illustrates a schematic flow for modifying the large pad area on selective areas of the wafer, according to an example embodiment;

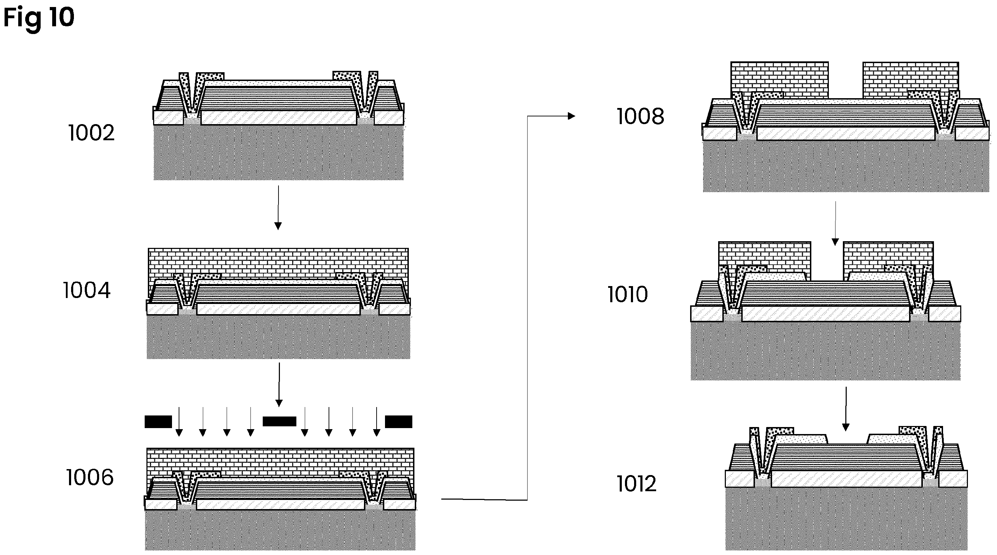

FIG. 10 illustrates a schematic flow for modifying the seed layer/UBM only;

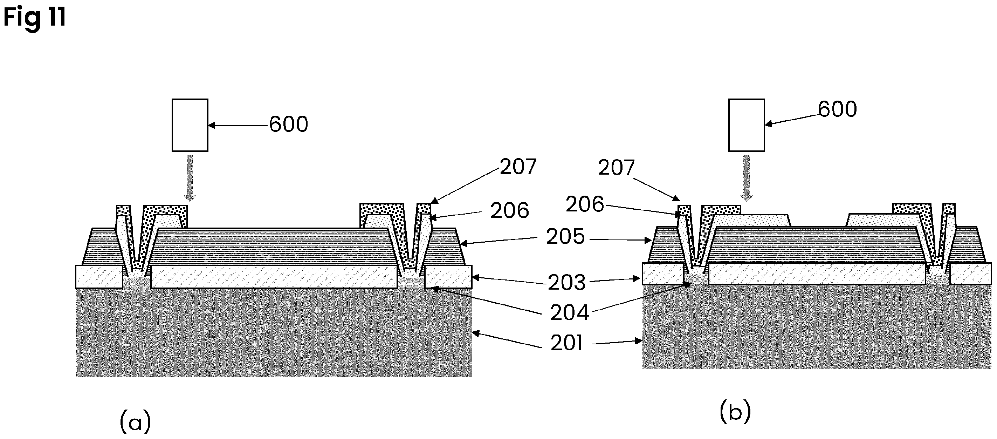

FIG. 11 illustrates modification of the capacitive area during pre-assembly, according to an embodiment of the invention.

Detailed description

The inventors have recognised and appreciated a solution that enables improved control of, and a reduction in the variation of the impedance over a semiconductor wafer during the processing stages to result in a final RFID assembly having a limited variation in performance and better manufacturing yield. Accordingly, this invention provides an improved semiconductor RFID device and a method of fabrication of the device.

A semiconductor device is described, the device comprising: a semiconductor RFID IC base layer; a passivation layer located over the base layer, having a metal insert within the passivation layer; a repassivation layer located over the passivation layer and the metal insert; a assembly pad layer located over the repassivation layer; wherein the device has: a first region R1 of the device, where a height of the repassivation layer is given by $d_1$, and region R1 is provided with an assembly pad in the assembly pad layer over the repassivation layer, that has an area $a_1$; and an nth region Rn of the device, where the height of the repassivation layer is given by $d_n$, where $d_1 > d_n$ and region Rn is provided with an assembly pad in the assembly pad layer over the repassivation layer, which has an area $a_n$, where $a_n > a_1$.

A method of forming a semiconductor device is described, the method comprising the steps of: providing a semiconductor RFID base layer; having a series of regions R1,... Rn, where R1 is the first region on the wafer, and Rn is the nth region, providing at least one metal insert on the interior of a top surface of the semiconductor RFID base layer; providing a first passivation layer on the top surface of the semiconductor RFID base layer, around the at least one metal insert; providing a repassivation layer over a top surface of the first passivation layer, and a top surface of an outer edge of the metal insert; depositing an under bump metallization layer on the exposed top surface of the metal insert, and inner sidewalls of the repassivation layer and a top surface of the repassivation layer; wherein a height of the repassivation layer in R1 is given by $d_1$, and region R1 is provided with an assembly pad over the repassivation layer, that has an area $A_1$; and wherein the height of the repassivation layer in region Rn is given by dn, where $d_1 > d_n$ and region RN is provided with an assembly pad over the repassivation layer, which has an area $A_n$, where $A_n > A_1$.

During a semiconductor fabrication process active layers are covered by a stack of metal layers and intermetal dielectric (IMD) layers. Process variation line and spacing width of metal features, in the thickness and composition of the IMD layers etc. are contributory reasons for impedance variations over the wafer. The semiconductor device will be provided with a passivation layer. The thickness of the passivation layer (d) can be controlled and, together with it, the introduced parasitic effects. A passivation layer is a protective coating applied to the surface of a semiconductor device, usually made from materials such as silicon dioxide ($SiO_2$) or silicon nitride ($Si_3N_4$). The primary purposes of a passivation layer are to shield the semiconductor IC from contaminants, moisture, and mechanical damage (this is important for maintaining the electrical function of the device) By providing a barrier against environmental factors, the passivation layer helps improve the longevity and stability of the semiconductor device.

RFID IC RF input impedance is a complex value that is non-linear with power. Typically, it has a highly reactive value that can be expressed in the following form:

$$Z\_in = R - jX; \qquad\qquad [1]$$

where R and X are positive numbers. This translates into a typical electrical circuit formed by a shunt/parallel resistor with a capacitor. The IC capacitance value $C\_(IC\_RF)$ is very sensitive to process variations and may therefore vary significantly over the wafer, whereas the resistance value $R\_(IC\_RF)$ is more stable over the wafer.

As shown in the graph of FIG.1, the RF input capacitance measured over the wafer 100 shows a strong dependency on the wafer location. Variation of input impedance has a strong impact on overall RFID label performances (for example a variation of 5% in the RF input impedance may have up to 3dB degradation in performance of the final RFID IC assembly).

The inventors have identified and appreciated that the real part of the RF input impedance has a quasi-constant distribution, whereas the reactive part (capacitance) varies over the wafer.

Thus, the inventors have identified and appreciated that the capacitance variation over the wafer is one of the key performance indicators of the RFID IC.

In addition to the intrinsic capacitance of the RF input (which varies over the wafer) it is also necessary to consider the parasitic capacitance given by the assembly pad(s) manufactured on top of the repassivation layer and electrically connected to the RF pads and the parasitic capacitance due to assembly onto the RFID antenna. The manufacture of these further layers is discussed with reference to later figures.

The Pad Capacitance is mainly defined by the Area of the Pad ('A'), the distance ('d') between the RF Pad and the IC metal structure and by the repassivation layer physics $(\varepsilon_r)$.

Thus, it is known that the Capacitance is a function of: Area, d, $\varepsilon_r$

By definition: a Capacitance between 2 metal plates is given by

$$C = \frac{\varepsilon A}{d} \;\rightarrow\; C_{p\_pad} = f(A, d, \varepsilon_r) \qquad\qquad [2]$$

The overall RF input Capacitance:

$$(C_{RF\_IN} = C_{IC\_RF} + C_{p\_pad}) \qquad\qquad [3]$$

Is given by the sum of the IC capacitance value and the Parasitic Pad capacitance, and this can be adjusted by acting on the assembly pad by varying d; A (the layout/area of the assembly ad) and by combining both to impact the effective dielectric constant, $\varepsilon_r$.

The inventors have identified and appreciated that a solution that will allow a semiconductor designer/manufacturer to control or reduce the variation of the impedance over the wafer will bring a final RFID assembly having a more limited variation in performance and thus a better manufacturing yield.

One envisaged possibility to compensate for this variation in capacitance over the wafer 100 is given by acting on the "post fabrication" process (i.e., backend processes). In the backend processes, both the redistribution layer (RDL) and Assembly pad layout can be defined in a way that the parasitic capacitance introduced by the assembly pads and RDL structure (repassivation layers and eventual traces) compensate for the change in the RF input impedance and bring it back to the desired nominal value.

However, an important factor is how the value of 'C * d' varies over the wafer to impact RFID products. In an example, the variation of metal and dielectric thickness among the various layers implies an overall change of the expected capacitance and resistance value of the devices. The consequence of those changes is typically reflected in the impedance value. It is desirable to reduce any deviation of the impedance value across the wafer to <2-3%.

The inventors have identified and appreciated that by moving from a centre of the wafer toward the edge of the wafer, the RF input impedance measured at the RF pads of the RFID IC may change due to the intrinsic effect of the wafer manufacturing process.

After the fabrication process, the wafer characteristics in terms of distribution of RF input impedance of the single ICs can be measured and used as a base for the definition of the repassivation layers structures and conductive bond pads layout.

The inventors have identified and appreciated that the Real part of the RF input impedance has a quasi-constant distribution, whereas the reactive part (capacitance) is varying over the wafer. Thus, the capacitance variation over wafer is one of the key performance indicators of the RFID IC.

In addition to the intrinsic capacitance of the RF input (which varies over the wafer) the inventors have identified and appreciated that it is useful to add the parasitic capacitance given by the assembly pad manufactured on top of the repassivation layer and electrically connected to the bond pads.

FIG. 4(a) shows a plan view of the semiconductor wafer 250, and three partial cross sections are illustrated in FIG. 4(b), FIG. 4(c), and FIG. 4(d) from different sections of the semiconductor die 201 (of FIG. 4(A)), FIG. 4(e) is a close up cross sectional view, showing the features in FIGs 4(b)-(d) in more detail.. As shown, the RFID semiconductor die 201, has a top surface 202. On this surface is a die passivation layer 203, surrounding a metal insert bond pad 204 typically formed of aluminium. In an embodiment, a semiconductor device is described, the device comprising: a semiconductor RFID IC base layer; a passivation layer located over the base layer, having a metal insert within the passivation layer; a repassivation layer located over the passivation layer and the metal insert.

Above the outer edges of the metal insert bond pad 204, and the top surface 211 of IC passivation layer 203, is a repassivation layer 205, preferably this is a polyimide layer, or a polybenzoxazole layer, with a height d. This repassivation layer 205 has a top surface 209,. In some examples, the repassivation layer 205 is added in order to insulate/separate a UBM layer (206) from the substrate and also to mechanically sustain them. As shown, each of the examples of FIGs 4(b-d) have different thicknesses of the Repassivation layer 205 to adapt the parasitic capacitance

Above the metal insert bond pad 204 is an Under Bump Metallization layer (UBM), 206 . This UBM layer (206) is located over the metal insert bond pad 204, and sidewalls of the repassivation layer 205, and also extends over the top surface 209 of the repassivation layer 205. UBM layer 206 is a TiW/Au sputtered layer, acts as a seed layer for electroplating, a barrier layer for the metal insert bond pad and an adhesion promoter for an Au plated layer. Preferably, the metallization layer is a layer (206) between the repassivation layer (205) and the assembly pad layer (207).

As shown, in one example, the UBM, may have slanting sidewalls, extending outwardly, from the top surface of metal insert bond pad 204. These sidewalls cover the side walls of the repassivation layer 205, and then extend over the top of the repassivation layer An assembly pad layer 207 is the provided over the top of the UBM layer 206 and is placed to cover all of the UBM over the repassivation layer 205, but not to extend further over the repassivation layer 205 than the UBM layer 206. Preferably, the assembly pad layer is an electroplated metal-pad ("bump") for connection with an RFID antenna ($200 \times 200 \mu m$ depending on IC size) . The metal for the large pad 207 is preferably Au or Cu. In some embodiments (for the final application, the large pad is connected to the antenna pad of the RFID antenna) an antenna contact pad is connected to the large pad 207,

The inner section of the semiconductor wafer 250 is section R1 252, the next (outward) section is labelled R2, 254, and the final section, on the outer part of the wafer 250 is R3 256. In this manner, sections R1, R2, and R3 form a series of concentric circles. In the embodiment as shown there are three concentric regions on the semiconductor wafer 250, but it is envisaged there could Rn concentric sections, where n is at least 2. In each of the regions Rn, the assembly pad will have area $A_n$, so area $A_1$ for region R1, area $A_2$ for region R2, and area $A_3$ for region R3. A shown, the regions are concentric regions on the semiconductor wafer, but regions R1, R2,... Rn may have any shape, and be located anywhere on the semiconductor wafer, the precise shape and placement of the different regions will be determined according to the specific device that is being fabricated.

The Parasitic capacitance of the repassivation layer 205 is function of the area and dielectric property of the material of the repassivation layer, $\varepsilon$ as well as distance, d, indicated in the figures, that is $d_1$ for R1, $d_2$ for R2, and so on:

$$C_{p\_pad\_1} = \frac{\varepsilon A}{d_1} \qquad\qquad [4]$$

The height of the passivation layer for region R1 252 is 'd$_1$', as illustrated in FIG. 4(b), the height of the passivation layer for region R2 254 is 'd$_2$', as illustrated in FIG. 4(c), and the height of the passivation layer for region R3 256 is 'da', as illustrated in FIG. 4(d), where:

$$d_1 > d_2 > d_3 \qquad\qquad [5]$$

In some examples, in order to compensate for an overall reduction of capacitance moving from the wafer centre towards the edge of the wafer, the thickness of the repassivation layer under the pad can be reduced accordingly with the effect to increase the equivalent parasitic capacitance and compensate for the intrinsic reduction of capacitance. In the below example we may consider (according to impedance distribution) to divide the wafer area into three areas that will be treated differently during the repassivation process. A repassivation layer 205 is an additional passivation layer, often used during subsequent processing steps.

Each area will have a different thickness of the repassivation layer with a consequent different impedance measured at RF assembly pads in each of regions R1, R2, and R3.

$$C_{p\_pad\_1} = \frac{\varepsilon A}{d_1} < C_{p\_pad\_2} = \frac{\varepsilon A}{d_2} < C_{p\_pad\_3} = \frac{\varepsilon A}{d_3} \qquad\qquad [6]$$

As illustrated, the parasitic capacitance between the RF assembly Pads and the IC conductive layer can be controlled by properly acting on the definition of the repassivation layer thickness over the wafer and on the layout of the RF assembly pad itself.

In some examples, in order to compensate for an overall reduction of capacitance, when moving from the wafer centre towards the edge of the area of the large assembly pad 207 placed on top of repassivation layer 205, the parasitic capacitance can be modified accordingly. For instance, in order to increase the overall capacitance, the overall area (A) of the area pad 207 can be increased while the distance between the repassivation layer 205 and die passivation layer 203 and metal layer 206 is kept constant. The area pad, is a flat, conductive region on the surface of a semiconductor chip, designed to serve as the interface between the semiconductor chip and the external environment, such as printed circuit boards (PCBs) or other ICs or the RFID inlay

The assembly Pad Capacitance is mainly defined by the Area of the Pad (A), the distance between the RF assembly Pad and IC metal structure (d) and by the repassivation layer physics ($\varepsilon_r$).

It is known that the Capacitance is a function of Area, A, distance d, and effective dielectric constant $\varepsilon_r$

By definition: Capacitance between two metal plates is given in equation [2] and the overall RF input Capacitance is given in equation [3], which relates to the sum of the IC capacitance value and the Parasitic Pad capacitance and can be adjusted by acting on the assembly pad by varying d; the pad area 'A' (e.g., its layout) and by combining both to impact the effective dielectric constant.

FIG. 5(a) illustrates a plan view of one example of RFID semiconductor wafer. again, with concentric regions R1, R2 and R3. according to some example embodiments. Figures 5(b)-5(d) illustrate plan views of and assembled RFID inlay and shows the assembly pad area (207), from each of regions R1, R2, and R3 respectively. As illustrated in FIG. 5(b), the repassivation layer 205, for region R1 has two area pads 207, with each area pad 207 formed on top of the repassivation layer 205. Preferably, the device includes an assembly pad layer located over the repassivation layer. As shown the assembly pad is generally rectangular in shape, and the area of the assembly pad increases from R1, to R2 to R3.

The area defining the capacitance is the overlap of the IC with the Antenna pad (601) and the protruding area of the large pads (602)

By modifying the area of the large assembly pad (207) in the protruding area (602), the capacitance in each of the regions R1, R2, R3 can be modified, so that (FIG6b ; FIG6c; FIG6d) the capacitance has the following relationship $C(R_1) < C(R_2) < C(R_3)$. In a preferred embodiment, there is an inner region R1 (252) of the device, where a height of the repassivation layer is given by d1, and region R1 is provided with an assembly pad in the assembly pad layer (207) over the repassivation layer, that has an area $A_1$; and an outer region RN (256) of the device, where the height of the repassivation layer is given by dn, where $d_1 > d_n$ and region RN is provided with an assembly pad in the assembly pad layer (207) over the repassivation layer, which has an area an, where $A_n > A_1$.

As shown in the figures, the large assembly pads 207 increase in size from R1 to R2 to R3. Preferably, the semiconductor device is provided with a series of regions R1, R2... Rn, arranged concentrically over the semiconductor device, wherein the height of the repassivation layer $d_n$ decreases in each sequential region, and wherein each region is provided with an assembly pad in the bump layer(207) over the repassivation layer, which has area an; where the area of the assembly pad (207) in each sequential region increases sequentially from $A_1$ to $A_n$.

The parasitic capacitance of the RF Pads vs IC can be controlled by properly acting on the large pad 207 defined on top of the repassivation layer 205.

In some examples, in order to compensate for an overall reduction of capacitance moving from wafer centre, region R1, towards the edge the area of the large pad placed on top of repassivation layer 205, the capacitance can be modified accordingly. For instance, in order to increase the overall capacitance, the area pad 207 area can be increased while the distance between repassivation layer 205 and die passivation layer 203 and metal layer 206 is kept constant (in a generalised representation of equation [6] shown below in equation [7]).

$$C_{p\_pad\_1} = \frac{\varepsilon A_1}{d} < C_{p\_pad\_2} = \frac{\varepsilon A_2}{d} < C_{p\_pad\_3} = \frac{\varepsilon A_3}{d} \qquad [7]$$

$$A_1 < A_2 < A_3 \qquad [8]$$

FIG. 6 illustrates an embodiment with cavities/intention in the passivation layer. In an embodiment of the invention the repassivation layer (205) of at least one of the regions R1 to RN is provided with a series of one or more cavities (401) within at least one of the assembly pad and/or the repassivation layer (205) of the specific region. Preferably, the series of cavities (401) in the repassivation layer (205) of at least one of regions R1 to RN is located underneath the assembly pad.. FIG. 6 (a) shows a top plan view of IC with fully metalized cavities (401) with area of intention $A_1$ being the area of a single cavity and area $A_2$ representing the effective capacitive area i.e. overlap area of the IC with an RFID antenna pad excluding the areas of the cavities.

FIG. 6 (b) is a cross-sectional view corresponding to the view of FIG. 6(a). The capacitance is defined by area of large pad (206 and 207), area of intention (401) and the respective distances (d2 and d1)

FIG. 6 (c) shows a top view of IC with non metalized cavities (402). FIG. 6(d): is a cross-sectional view corresponding to the plan view of FIG. 6(c). Preferably, the cavities (401) in the repassivation layer in each of the regions R1 to Rn, have a depth that is different for each of the regions R1,...Rn. In an embodiment, the depth for each of the cavities (401) in successive regions is less than the depth of the cavities in the previous region.

Capacitance is now defined by the area of the large pad only, as during assembly the cavity will typically be filled with an adhesive which has a similar dielectric constants as the repassivation layer. Preferably, one or more of the cavities (401) or slots (701) are filled with adhesive.

In the shown example of n cavities under a large pad, (where n=7 in the embodiment as shown) the capacity for a single pad is given by Eqn [9]

$$C_{p_{pad}-trench\ fully\ metalized} = \frac{\varepsilon_{eff1m}A2}{d_2} + n\,\frac{\varepsilon_{eff2m}A1}{d_1}$$

Where $\varepsilon_{eff1}$ and $\varepsilon_{eff2}$ are the effective dielectric constants, that will vary, due to the different ratios between the first passivation layer 203, and the second passivation layer in the different regions R1 and R2.

In case all cavities are non- metalized, the capacity for a single pad is given by Eqn [10]

$$C_{p_{pad}-non\ metalized} = \frac{\varepsilon_{eff1m}A2}{d_2} + n\,\frac{\varepsilon_{eff2nm}A1}{d_2}$$

This allows the parasitic capacitance of the RF Pads vs IC to be controlled by properly metalizing the cavities. In some examples, this action may be combined with thickness variation of the cavities in order to improve the effect and provide additional gain on capacitance compensation gain.

FIG. 7: shows an example embodiment with additional grooves in the repassivation layer (205). FIG. 7 a: shows a top plan view of IC with fully metalized grooves/trenches/slots (701)) with an area A4 representing the effective capacitive area i.e. overlap area of the IC with an RFID antenna pad excluding the areas of the trench. In an embodiment, the assembly pad of at least one of the regions $R_1$ to $R_N$ is provided with one or more slots (701) located within at least one of the assembly pad or the repassivation layer (205) of the specific region. Preferably, wherein the one or more slots (701) in the repassivation layer of at least one of regions R1 to RN is located underneath the assembly pad. Further preferably, the one or more slots (701) in the repassivation layer in each of the regions R1 to RN, have a depth that is different for each of the regions R1,...Rn. In an embodiment, the depth for each of the one or more slots (701) in successive regions R1,..Rn is less than the depth of the cavities in the previous region.

FIG. 7 (b) is a cross-sectional view corresponding to FIG. 7(a). The capacitance for this embodiment is defined by the overlap area between IC and RFID antenna pad 304 area groove (701) and the respective distances (d2 and d1). The relevant equation for the capacitance of a single pad is given by Eqn [11]:

$$C_{p_{pad}-trench\ fully\ metalized} = \frac{\varepsilon_{eff1m}A_4}{d_2} + \frac{\varepsilon_{eff2m}A_3}{d_1}$$

FIG. 7 c: Top view of IC with non metalized grooves / trenches (702), where the metallisation in trench is fully removed. FIG. 7(d) is the corresponding cross sectional view. In an embodiment, the metallization layer (206) is at least partially removed from the cavities (401) or the slots (701) in the repassivation layer (205). Preferably, one or more of the or slots (701) are filled with adhesive. The Capacitance is now defined by the area of the overlap the dielectric constant in the slot is neglected, as the slot is filled with adhesive . The equation is then given by eqn [12]

$$C_{p_{pad}-trench\ non\ metalized} = \frac{\varepsilon_{eff1m}A_4}{d_2} + \frac{\varepsilon_{eff2nm}A_3}{d_2}$$

With $d_2$ the sum of thicknesses of the IC passivation layer (203) and the repassivation layer (205). $d_1$ can be adapted as needed between minimal the thickness of the IC passivation layer (205) but always smaller than $d_2$.

In an alternative embodiment, the cavities (as shown in FIG. 6) or trenches (as shown in Fig. 7) might be processed first without metallisation, but are filled with a conductive material in a subsequent step to achieve the same result.

FIG. 8: shows a schematic flow of the steps for a modified repassivation process to adapt the PI layer thickness on different areas of the wafer. Initial stage 802 is PI coating, followed by PI exposure negative at 804, and then PI developing at 806. To increase the PI layer thickness in selected areas of the wafer PI coating is again performed (808)

By using a Mask 1 (810) which fully covers the IC in regions of the wafer where no additional Repassivation is required, the additional PI will be stripped completely during the development step. In regions of the wafer, where a thicker repassivation is required Mask 2 is used (812), only covering the metal insert bond pads, thus increasing the overall repassivation thickness.

Subsequently, the standard process step developing (814) and curing (816) are applied, resulting in different repassivation thicknesses. After this, the process is continued as shown in FIG. 4 with seed layer/UBM sputtering (TiW/Au flash).

FIG. 8 refers to FIG. 2, showing that the PI-layer deposition can be repeated to increase the PI layer thickness. By using different masks in different wafer areas, the thickness can be selectively adapted as needed (in case of reticule masks), in case of a full wafer mask would have separate areas with different pattern.

Alternatively, the PI layer thickness can be adapted by other ablative processes (e.g. laser ablation) on selective areas of the wafer)

FIG. 9: is a schematic flow of the steps required for modifying the large pad area on selective areas of the wafer

FIG. 9 refers back to FIG. 4 and shows the process for Bump flow for different pad shapes / modification of the pad area in an example embodiment. In this case the full wafer is processed as shown in FIG. 4 until PR coating. After this process step, region of the wafer where pads with area A1 are required, are irradiated with Mask 1, region of the wafer where pads with area A2 are required, are irradiated with Mask 2. The full wafer is than further processed according to the flow shown in FIG. 4 Steps 902 and 904 correspond to step 234 in FIG.2 (PR exposure), step 906 corresponds to step 236 (PR developing) in FIG.2 and step 908 corresponds to step 240, (PR stripping) in FIG. 2.

FIG. 10: is a schematic process according to an embodiment for modifying the seed layer or UBM layer 206 of the semiconductor wafer 250. The process allows for the provision of different pad shapes / modification of the pad areas in the seed layer only. The process refers again to the process flow shown in FIG. 4. In this case, the after Galvano plating and stripping the PR-stripping, another PR is applied step 1004, irradiated with a mask at step 1006, developed respectively cured at step 1008, UBM etched at step 1010 and stripped at step 1012.

It might be advantageous to process the seed layer/UBM only for modifying the capacitance: to reduce the amount of Au or especially in case of a removing of the layer by e.g. ablative laser. As the seed layer is much thinner, less energy laser system can be used with lower cost and a higher process time.

FIG. 11(a) illustrates the modification of the capacitive area for single ICs during a preassembly process, for example using a laser ablation system 600 on the full plated area. FIG. 11(b) is an alternative embodiment where only the seed layer undergoes a laser treatment/structuring. In this case, less power is need and the process will generally be faster.

In an example, the capacitance modification is not done by a mask process, and assuming a stable variation of IC capacitance variation, the pad areas can be modified by an ablative process e.g. by laser 600. The full plated area may be treated by the laser. Or only a seed layer is treated by the laser.

Assuming the capacitance of every single IC can be measured during wafer test (either prior to bumping process, or after bumping process), a Laser marking equipment or Laser grooving equipment can be used, to modify the capacitive area for every single IC on a wafer.

In the foregoing specification, the invention has been described with reference to specific examples of embodiments of the invention. It will, however, be evident that various modifications and changes may be made therein without departing from the scope of the invention as set forth in the appended claims and that the claims are not limited to the specific examples described above.

The connections as discussed herein may be any type of connection suitable to transfer signals from or to the respective nodes, units or devices, for example via intermediate devices. Accordingly, unless implied or stated otherwise, the connections may for example be direct connections or indirect connections. The connections may be illustrated or described in reference to being a single connection, a plurality of connections, unidirectional connections, or bidirectional connections. However, different embodiments may vary the implementation of the connections. For example, separate unidirectional connections may be used rather than bidirectional connections and vice versa. Also, plurality of connections may be replaced with a single connection that transfers multiple signals serially or in a time multiplexed manner. Likewise, single connections carrying multiple signals may be separated out into various different connections carrying subsets of these signals. Therefore, many options exist for transferring signals. Those skilled in the art will recognize that the architectures depicted herein are merely exemplary, and that in fact many other architectures can be implemented which achieve the same functionality.

Any arrangement of components to achieve the same functionality is effectively 'associated' such that the desired functionality is achieved. Hence, any two components herein combined to achieve a particular functionality can be seen as 'associated with' each other such that the desired functionality is achieved, irrespective of architectures or intermediary components. Likewise, any two components so associated can also be viewed as being 'operably connected,' or 'operably coupled,' to each other to achieve the desired functionality.

Furthermore, those skilled in the art will recognize that boundaries between the above-described operations merely illustrative. The multiple operations may be combined into a single operation, a single operation may be distributed in additional operations and operations may be executed at least partially overlapping in time. Moreover, alternative embodiments may include multiple instances of a particular operation, and the order of operations may be altered in various other embodiments. Also, for example, in one embodiment, the illustrated examples may be implemented as circuitry located on a single integrated circuit or within a same device, such as an RFID IC.

In some examples, the various components within the RFID IC can be realized in discrete or integrated component form, with an ultimate structure therefore being an application-specific or design selection. As the illustrated embodiments of the present invention may, for the most part, be implemented using electronic components and circuits known to those skilled in the art, details will not be explained in any greater extent than that considered necessary as illustrated below, for the understanding and appreciation of the underlying concepts of the present invention and in order not to obfuscate or distract from the teachings of the present invention. A skilled artisan will appreciate that the level of integration of circuits or components may be, in some instances, implementation dependent.

In the claims, any reference signs placed between parentheses shall not be construed as limiting the claim. The word 'comprising' does not exclude the presence of other elements or steps then those listed in a claim. Furthermore, the terms 'a' or 'an,' as used herein, are defined as one or more than one. Also, the use of introductory phrases such as 'at least one' and 'one or more' in the claims should not be construed to imply that the introduction of another claim element by the indefinite articles 'a' or 'an' limits any particular claim containing such introduced claim element to inventions containing only one such element, even when the same claim includes the introductory phrases 'one or more' or 'at least one' and indefinite articles such as 'a' or 'an.' The same holds true for the use of definite articles. Unless stated otherwise, terms such as 'first' and 'second' are used to arbitrarily distinguish between the elements such terms describe. Thus, these terms are not necessarily intended to indicate temporal or other prioritization of such elements. The mere fact that certain measures are recited in mutually different claims does not indicate that a combination of these measures cannot be used to advantage.

## Claims

1. A semiconductor device comprising:

a semiconductor RFID IC base layer (201);
a passivation layer (203) located over the base layer, having a metal insert (204) within the passivation layer;
a repassivation layer (205) located over the passivation layer and the metal insert;
an assembly pad layer (207) located over the repassivation layer;

wherein the device has:

an first region R1 (252) of the device, where a height of the repassivation layer is given by $d_1$, and region R1 is provided with an assembly pad in the assembly pad layer (207) over the repassivation layer, that has an area $A_1$; and

an nth region Rn (256) of the device, where the height of the repassivation layer is given by $d_n$, where $d_1 > d_n$ and region Rn is provided with an assembly pad in the assembly pad layer (207) over the repassivation layer, which has an area $A_n$, where $A_n > A_1$.

2. The semiconductor device as claimed in claim 1, wherein the semiconductor device is provided with a series of regions R1, R2... Rn, arranged in different locations on the semiconductor device, wherein the height of the repassivation layer $d_n$ decreases in each sequential region, and wherein each region is provided with an assembly pad in the assembly pad layer(207) over the repassivation layer, which has area $A_n$; where the area of the assembly pad (207) in each sequential region increases sequentially from $A_1$ to $A_n$.

3. The semiconductor device of any preceding claim further comprising a metallization layer (206) between the repassivation layer (205) and the assembly pad layer (207).

4. The semiconductor device of any preceding claim , wherein the repassivation layer (205) of at least one of the regions R1 to RN is provided with a series of one or more cavities (401) connected with one of the assembly pad layer (207) or the repassivation layer (205) of the specific region.

5. The semiconductor device of claim 4 wherein the series of cavities (401) in the repassivation layer (205) of at least one of regions R1 to RN is located underneath the antenna pad (304).

6. The semiconductor device as claimed in claim 4 or claim 5 wherein the cavities (401) in the repassivation layer (205) in each of the regions R1 to Rn, have a depth that is different for each of the regions R1,... Rn.

7. The semiconductor device as claimed in claim 6 wherein the depth for each of the cavities (401) in successive regions is less than the depth of the cavities in the previous region.

8. The semiconductor device of any preceding claim wherein the assembly pad of at least one of the regions R1 to RN is provided with one or more slots (701) connected with located within at least one of the assembly pad or the repassivation layer (205) of the specific region.

9. The semiconductor device of claim 8 wherein the one or more slots (701) in the repassivation layer of at least one of regions R1 to Rn is located underneath the. antenna pads

10. The semiconductor device of claim 9 wherein the one or more slots (701) in the repassivation layer in each of the regions R1 to Rn, have a depth that is different for each of the regions R1,...Rn.

11. The semiconductor device of claim 10 wherein the depth for each of the one or more slots (701) in successive regions R1,..Rn is less than the depth of the slots in the previous region.

12. The semiconductor device as claimed in any of claims 3 to 11 wherein the metallization layer (206) is at least partially removed from the cavities (401) or the slots (701) in the repassivation layer (205).

13. The semiconductor device as claimed in any of claims 3 to 11 wherein one or more of the cavities (401) or slots (701) are filled with adhesive.

14. The semiconductor device as claimed in any preceding claim wherein the assembly pad is an electroplated metal pad.

15. A method of forming a semiconductor device comprising the steps of:

providing a semiconductor RFID base layer (201); having a series of regions R1,...Rn, where R1 is a first region on a wafer, and Rn is the nth region on a wafer (250),

providing at least one metal insert (204) on an interior part of a top surface of the semiconductor RFID base layer;

providing a first passivation layer (203) on the top surface of the semiconductor RFID base layer, around the at least one metal insert;

providing a repassivation layer (205) over a top surface of the first passivation layer, and a top surface of an outer edge of the metal insert;

depositing an under-bump metallization layer (206) on an exposed top surface of the metal insert, and inner sidewalls of the repassivation layer and a top surface of the repassivation layer;

wherein a height of the repassivation layer in R1 is given by $d_1$, and region R1 is provided with an assembly pad (207) over the repassivation layer (205), that has an area $A_1$; and

wherein the height of the repassivation layer (205) in region Rn is given by $d_n$, where $d_1 > d_n$ and region RN is provided with an assembly pad (207) over the repassivation layer (205), which has an area $a_n$, where $A_n > A_1$.

FIG 1   Prior art

**FIG 2** Prior art

100 →

220 · 204 · 203 — Thick unsawn wafer

201

222 → PI coating

224 → PI exposure negative

226 → PI developing

205

228 → PI hard cure

206

230 → Seed layer sputter TiW, Au

232 → PR coating

207

234 ← PR exposure negative

236 ← PR developing

238 ← Galvano plating

240 ← PR stripping

242 ← Seed layer etching Au-etching, TiW etching

← 244

EP 4 738 432 A1

FIG 3  Prior art

EP 4 738 432 A1

15

FIG 4

EP 4 738 432 A1

**FIG 4(e)**

FIG 5

**FIG 6**

EP 4 738 432 A1

**FIG 7**

EP 4 738 432 A1

# FIG 8

802 → PI coating

804 → PI exposure negative

806 → PI developing

808 → PI coating

Mask 1

810 →

Mask 2

812 → PI exposure negative

814 →

814 → PI developing

816 →   d₁   d₂   816 → PI hard cure

• FIG 9

Mask 1      $A_1$      $A_2$      Mask 2

902 →          ← 904

906 →          ← 906

$A_1$      $A_2$

908 →          ← 908

EP 4 738 432 A1

# Fig 10

1002

1004

1006

1008

1010

1012

EP 4 738 432 A1

Fig 11

(a)

(b)

**EUROPEAN SEARCH REPORT**

Application Number

EP 24 20 9456

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2010/148812 A1 (NAGAI NORIYUKI [JP] ET AL) 17 June 2010 (2010-06-17) | 1-4,8-15 | INV. H01L23/00 |
| A | * paragraph [0002] * <br> * paragraphs [0050] - [0055] * <br> * paragraphs [0100] - [0108] * <br> * figures 7-9 * <br> ----- | 5-7 | |

**TECHNICAL FIELDS SEARCHED (IPC)**

H01L

The present search report has been drawn up for all claims

| Place of search | Date of completion of the search | Examiner |
|---|---|---|
| The Hague | 26 March 2025 | Keller, Jan |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 20 9456

This annex lists the patent family members relating to the patent documents cited in the above-mentioned European search report.
The members are as contained in the European Patent Office EDP file on
The European Patent Office is in no way liable for these particulars which are merely given for the purpose of information.

26-03-2025

| Patent document cited in search report | Publication date | Patent family member(s) | | Publication date |
|---|---|---|---|---|
| US 2010148812 A1 | 17-06-2010 | JP | 5186344 B2 | 17-04-2013 |
| | | JP | 2010129959 A | 10-06-2010 |
| | | US | 2010148812 A1 | 17-06-2010 |
| | | WO | 2010064341 A1 | 10-06-2010 |

For more details about this annex : see Official Journal of the European Patent Office, No. 12/82